Europäisches Patentamt

European Patent Office

Office européen des brevets

(11) Veröffentlichungsnummer: **0 503 455 A2**

# EUROPÄISCHE PATENTANMELDUNG

(21) Anmeldenummer: **92103669.5**

(22) Anmeldetag: **04.03.92**

(51) Int. Cl.5: **H01L 25/16**

(30) Priorität: **14.03.91 DE 4108154**

(43) Veröffentlichungstag der Anmeldung:
**16.09.92 Patentblatt 92/38**

(84) Benannte Vertragsstaaten:
**DE FR GB IT**

(71) Anmelder: **TELEFUNKEN electronic GmbH
Theresienstrasse 2
W-7100 Heilbronn(DE)**

(72) Erfinder: **Leicht, Günter
Neukreuthstrasse 11
W-8602 Stegaurach(DE)**
Erfinder: **Schuch, Bernhard
Schlossbergstrasse 15
W-8801 Neusitzz(DE)**

(74) Vertreter: **Maute, Hans-Jürgen, Dipl.-Ing.
TELEFUNKEN electronic GmbH
Theresienstrasse 2
W-7100 Heilbronn(DE)**

(54) Elektronische Baugruppe und Verfahren zur Herstellung von elektronischen Baugruppen.

(57) Bei einer elektronischen Baugruppe, deren Bauteile bzw. Schaltungskomponenten zu mindestens zwei Unterbaugruppen bzw. Funktionseinheiten zusammengefaßt werden, sind eine oder mehrere der Unterbaugruppen bzw. Funktionseinheiten auf einem ersten Substrat aus einem ersten Substratmaterial angeordnet. Das erste Substrat ist wiederum zusammen mit einer oder mehreren weiteren Unterbaugruppen bzw. Funktionseinheiten auf einem zweiten Substrat aus einem zweiten Substratmaterial angeordnet.

FIG.

Schaltungen von elektronischen Baugruppen, beispielsweise von elektronischen Steuergeräten, weisen als Unterbaugruppen bzw. Funktionseinheiten in der Regel eine Eingangsstufe, einen digital arbeitenden Steuerteil und eine Ausgangs-/Leistungsstufe auf. Als Substratträger für die Bauelemente sowie die elektrischen Verbindungsleitungen Zwischen den Bauelementen werden starre oder flexible Kunststoff-Leiterplatten, Keramiksubstrate sowie Leistungsrahmen (Leadframes) eingesetzt.

Die Kosten für den zum Aufbau der Schaltung notwendigen Substratträger werden von seiner Komplexität bestimmt: In nur einer Ebene verdrahtete Substratträger mit standardisierten Leiterbahnbreiten und Leiterbahnabständen sind Substratträgern, die in mehreren Ebenen verdrahtet sind, Substrat-Durchkontaktierungen enthalten und bezüglich Leiterbahnbreite und Leiterbahnabstände nicht standardisiert sind, kostenmäßig überlegen. Der Kostenfaktor gewinnt immer mehr an Einfluß, je mehr sich die gewählte Substrat-Technologie ihren technologischen Grenzen nähert; dies tritt meist dann ein, wenn das Design der Schaltung von Platzrestriktionen stark mitbestimmt wird.

Inbesondere wenn zur Realisierung des oben genannten digitalen Steuerteils mehrere Digital-ICs mit einer hohen Zahl von Anschlüssen untereinander zu verbinden sind, wird - abgesehen vom unverhältnismäßig hohen Platzbedarf der verwendeten Gehäuse in Relation zum eigentlichen Halbleiter-Chip - für die reine Leiterbahnverbindung sehr viel Platz oder eine ausgereizte Technologie auf dem Substratträger benötigt.

Der Erfindung liegt die Aufgabe zugrunde, den Herstellungs- und Kostenaufwand von elektronischen Baugruppen zu verringern und gleichzeitig den Platzbedarf dieser Baugruppen wesentlich zu reduzieren.

Diese Aufgabe wird erfindungsgemäß durch die Merkmale im Kennzeichen des Patentanspruchs 1 gelöst.

Vorteilhafte Weiterbildungen der Erfindung ergeben sich aus den Unteransprüchen.

Gemäß der Erfindung ist eine spezielle Aufbau- und Verbindungstechnik für elektronische Baugruppen realisiert, die zwei unterschiedliche Substrat-Technologien - vorzugsweise die Silizium-Planar-Technologie und beispielsweise die Hybrid-Technologie auf Keramiksubstrat oder die Leiterplatten-Technologie auf Kunststoffsubstrat - miteinander kombiniert. Verschiedene Unterbaugruppen bzw. Funktionseinheiten lassen sich in der für sie kostenoptimalen Substrat-Technologie realisieren. Im Falle der eingangs beschriebenen funktionsmäßigen Unterteilung des elektronischen Steuergeräts ist es vorteilhaft, die Unterbaugruppe des digitalen Steuerteils auf einem Silizium-Substrat, das ausschließlich Leiterbahnen und eine Passivierungsschicht enthält, zu realisieren; die benötigten Leiterbahnbreiten und -abstände sind dabei völlig unproblematisch. Auf das Silizium-Substrat werden Digital-ICs als ungehäuste Halbleiter-Chips aufgebracht, beispielsweise geklebt, und deren Anschlußflecken - beispielsweise durch Bonden - mit den Leiterbahnen des Substrats verbunden; zusätzlich können weitere Halbleiterbauelemente und passive Komponenten aufgebracht, beispielsweise aufgeklebt, werden. Die so entstandene Unterbaugruppe kann entweder auf einen Leitungsrahmen (Leadframe) montiert, gebondet und zu einem Gehäuse ummoldet werden, das dann auf ein zweites Substrat - das den Rest der Bauelemente der Gesamtbaugruppe trägt - montiert wird; alternativ dazu kann die Unterbaugruppe aber auch direkt auf ein zweites Substrat - beispielsweise auf eine Keramik-Hybridschaltung - die den Rest der Bauelemente der Gesamtbaugruppe trägt - aufgebracht werden, beispielweise durch Kleben und Bonden. In beiden Fällen kann die Leitbahnverbindung der Bauelemente auf dem zweiten Substrat - da es von der Verdrahtung der Digital-ICs entlastet ist - mit nur einer Metallisierungsebene - mit standardisierten Leiterbahnbreiten und Leiterbahnabständen und ohne Substrat-Durchkontaktierungen - realisiert werden. Die Kosten für die Herstellung der Unterbaugruppe - auf einem extrem einfachen Silizium-Substrat - werden durch die Vereinfachung im Aufbau der Gesamtbaugruppe und insbesondere durch die extreme Vereinfachung des sie tragenden zweiten Substrats mehr als kompensiert. Darüber hinaus kann - neben der Montagevereinfachung - aufgrund der verwendeten und leicht beherrschbaren Substrat-Technologien eine hohe Qualität (Zuverlässigkeit, Ausbeute) erzielt werden.

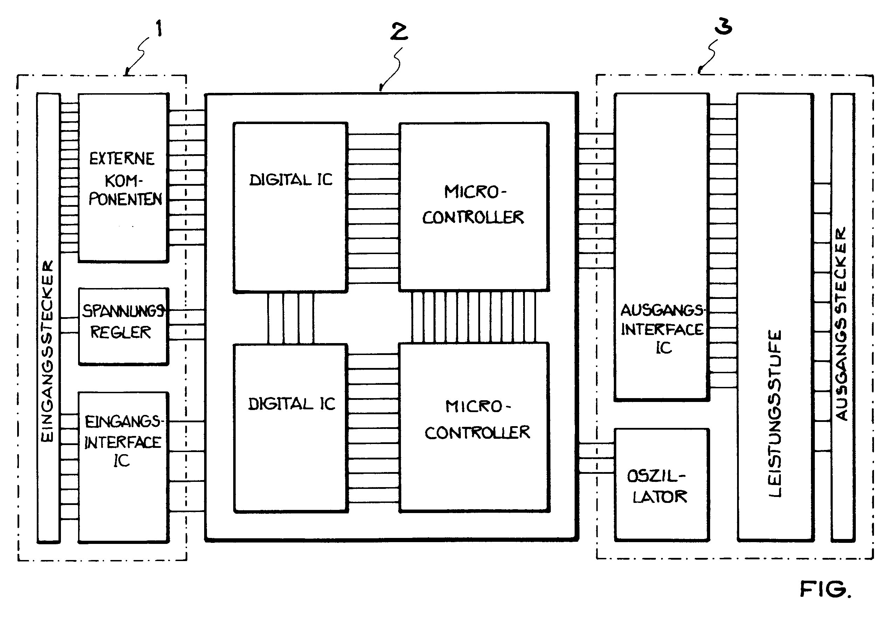

Die Erfindung soll nachstehend weiter beschrieben werden, wobei in der Figur das Prinzipschaltbild eines Steuergeräts für den Kfz-Bereich dargestellt ist.

Gemäß diesem Prinzipschaltbild besteht das Kfz-Steuergerät aus den Funktionseinheiten Eingangsstufe 1, Steuer-/Kontrollteil 2 und Ausgangsstufe 3, wobei der Steuer-/Kontrollteil 2 in Silizium-Technologie, die Eingangsstufe 1 und die Ausgangsstufe 3 beispielsweise in Dickschicht-Hybrid-Technologie realisiert ist. Die Eingangsstufe 1 umfaßt beispielsweise einen Eingangsstecker, externe Schaltungskomponenten, einen Spannungsregler und ein - beispielsweise bipolar aufgebautes - Eingangs-Interface-IC. Der Steuer-/Kontrollteil 2 besteht beispielsweise aus vier intergrierten Schaltkreisen, beispielsweise in CMOS-Technologie; dabei sind beispielsweise zwei digitale ICs zur Datenaufbereitung und Datenspeicherung und zwei Microcontroller zur Signalverarbeitung vorgesehen. Die Ausgangsstufe ist beispielsweise aus einem Ausgangs-Interface-IC (bipolar), einem Oszillator, einer Leistungsstufe und einem Ausgangsstecker aufgebaut. Die Silizium-Technologie verwendet ein Standard-Siliziumsubstrat - Fläche beispielsweise 17 x 15 mm$^2$ -, eine Leitbahnschicht - beispielsweise aufgesputterte oder aufgedampfte Aluminium-Leitbahnen mit 1 $\mu$m Dicke, 50 $\mu$m Breite und 50 $\mu$m Abstand - und eine Passivierungsschicht. Auf das Silizium-Substrat werden die vier oben beschriebenen digitalen, integrierten Schaltkreise als Chips aufgeklebt und auf dem Silizium-Substrat gebondet ("Chip-and-Wire"-Technik). Anschließend wird das Silizium-Substrat ("Multi-Chip-Modul") auf das Substrat der Hybridschaltung aufgeklebt und mit den Unterbaugruppen der Hybridschaltung, beispielsweise durch Löten oder Bonden verbunden, so daß die Funktion der Gesamtschaltung gebildet wird.

Für die Dickschicht-Hybrid-Technologie wird ein keramisches Aluminium-Substrat eingesetzt - Fläche beispielsweise 50 x 60 mm$^2$ - auf der eine Leitbahnschicht - beispielsweise 200 $\mu$m Breite, 200 $\mu$m Abstand - angeordnet ist; es wird ebenfalls nur eine Passivierungsschicht benötigt. Alle Halbleiterbauelemente werden in der oben beschriebenen Chip-and-Wire-Technik aufgebracht, alle SMD-Bauelemente werden aufgeklebt.

Verglichen mit einem herkömmlichen Aufbau des Steuergeräts - Gesamt-Hybridfläche 7400 mm$^2$ - ist nunmehr lediglich ein Platzbedarf von 4200 mm$^2$ notwendig. Aufwendige Durchkontaktierungen entfallen, da keine Mehrschichtstruktur erforderlich ist.

**Patentansprüche**

1. Elektronische Baugruppe, dadurch gekennzeichnet, daß die Bauteile bzw. Schaltungskomponenten der Baugruppe zu mindestens zwei Unterbaugruppen (1, 2, 3) bzw. Funktionseinheiten zusammengefaßt werden, daß eine oder mehrere der Unterbaugruppen (2) bzw. Funktionseinheiten auf einem ersten Substrat aus einem ersten Substratmaterial angeordnet sind, und daß das erste Substrat zusammen mit einer oder mehreren weiteren Unterbaugruppen (1, 3) bzw. Funktionseinheiten auf einem zweiten Substrat aus einem zweiten Substratmaterial angeordnet ist.

2. Elektronische Baugruppe nach Anspruch 1, dadurch gekennzeichnet, daß das erste Substratmaterial aus Silizium besteht.

3. Elektronische Baugruppe nach Anspruch 1 oder 2, dadurch gekennzeichnet, daß das zweite Substrat als Hybrid-Keramik ausgebildet ist.

4. Elektronische Baugruppe nach Anspruch 1 oder 2, dadurch gekennzeichnet, daß das zweite Substrat als Leiterplatte ausgebildet ist.

5. Elektronische Baugruppe nach Anspruch 4, dadurch gekennzeichnet, daß die Leiterplatte starr oder flexibel ist.

6. Elektronische Baugruppe nach Anspruch 1 oder 2, dadurch gekennzeichnet, daß das zweite Substrat als Leitungsrahmen (Leadframe) ausgebildet ist.

7. Elektronische Baugruppe nach einem der Ansprüche 2 bis 6, dadurch gekennzeichnet, daß auf dem Siliziumsubstrat integrierte Schaltkreise aus Silizium aufgebracht sind.

8. Elektronische Baugruppe nach Anspruch 7, dadurch gekennzeichnet, daß auf dem Siliziumsubstrat Verbindungsleitbahnen angeordnet sind.

9. Elektronische Baugruppe nach Anspruch 7 oder 8, dadurch gekennzeichnet, daß auf dem Siliziumsubstrat zusätzliche passive oder aktive Bauelemente aufgebracht sind.

10. Elektronische Baugruppe nach einem der Ansprüche 1 bis 9, dadurch gekennzeichnet, daß das Siliziumsubstrat auf das zweite Substrat geklebt ist.

11. Elektronische Baugruppe nach Anspruch 9, dadurch gekennzeichnet, daß das Siliziumsubstrat mit dem zweiten Substrat durch Löten verbunden ist.

12. Elektronische Baugruppe nach Anspruch 9, dadurch gekennzeichnet, daß das Siliziumsubstrat mit dem zweiten Substrat durch Bonden verbunden ist.

13. Verfahren zur Herstellung von elektronischen Baugruppen nach Anspruch 1 bis 12, dadurch gekennzeichnet, daß aus der Baugruppe Unterbaugruppen bzw. Funktionseinheiten gebildet werden, daß die Unterbaugruppen auf zwei mit unterschiedlichen Substrat-Technologien realisierten Substraten angeordnet werden, und daß die Gesamtfunktion der Baugruppe durch Verknüpfung aller Unterbaugruppen erreicht wird.

14. Verfahren nach Anspruch 13, dadurch gekennzeichnet, daß als erste Substrat-Technologie die Silizium-Planar-Technologie und als zweite Substrat-Technologie die Hybrid-Technologie und/oder die Leiterplattentechnologie und/oder die Folientechnologie und/oder Leitungsrahmen (Leadframes) verwendet werden.

15. Verfahren nach Anspruch 13 oder 14, dadurch gekennzeichnet, daß das erste Substrat auf bzw. mit dem zweiten Substrat verbunden wird.

FIG.

EP 0 503 455 A2